# EUROPEAN PATENT APPLICATION

(11) **EP 4 636 902 A1**
(43) Date of publication of application: **22.10.2025**
(21) Application number: 24744883.0
(22) Date of filing: 17.01.2024
(51) Int. Cl.: H01M 10/42, H01M 10/48

(54) **BATTERY TEMPERATURE ESTIMATION DEVICE AND OPERATION METHOD THEREOF**

(30) Priority: 20.01.2023 KR 20230009080
(71) Applicant: LG Energy Solution, Ltd., Seoul 07335 (KR)
(72) Inventor: KIM, Young Hwan, Daejeon 34122 (KR)
(74) Representative: Plasseraud IP
(86) International application number: PCT/KR2024/000858
(87) International publication number: WO 2024/155103

(57) **Abstract**

A battery temperature estimation apparatus according to an embodiment disclosed herein includes a data obtaining unit configured to obtain electrochemical impedance spectroscopy (EIS) data of a battery unit, a data extracting unit configured to extract a parameter value of a designated element of an equivalent circuit of the battery unit, based on the EIS data, and an identifying unit configured to identify, based on reference parameter values according to different temperatures, obtained based on reference battery units of a same type as the battery unit, a temperature value corresponding to the extracted parameter value and identify the temperature value as a temperature value of the battery unit at a time of obtaining the EIS data.

## Description

### [TECHNICAL FIELD]

### CROSS-REFERENCE TO RELATED APPLICATION

This application claims priority to and the benefit of Korean Patent Application No. 10-2023-0009080 filed in the Korean Intellectual Property Office on January 20, 2023, the entire content of which is incorporated herein by reference.

### TECHNICAL FIELD

Embodiments disclosed herein relate to a battery temperature estimation apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

### [DISCLOSURE]

### [TECHNICAL PROBLEM]

In the absence of a temperature sensor inside a battery, it is difficult to measure an accurate temperature of the battery. In addition, when the accurate temperature of the battery is not measured, it may be difficult to precisely measure other parameters (e.g., SOC, SOH) of the battery affected by the temperature.

Moreover, when communication information of the battery is not recognized (e.g., a communication scheme or a signal configuration of the battery is not released, it may be difficult to receive temperature information measured by the battery from the battery.

Thus, there is a need for a scheme to measure the temperature of the battery even when the temperature sensor is not present inside the battery or communication with the battery is difficult to make.

Technical problems of the embodiments disclosed herein are not limited to the above-described technical problems, and other unmentioned technical problems would be clearly understood by one of ordinary skill in the art from the following description.

### [TECHNICAL SOLUTION]

A battery temperature estimation apparatus according to an embodiment disclosed herein includes a data obtaining unit configured to obtain electrochemical impedance spectroscopy (EIS) data of a battery unit, a data extracting unit configured to extract a parameter value of a designated element of an equivalent circuit of the battery unit, based on the EIS data, and an identifying unit configured to identify, based on reference parameter values according to different temperatures, obtained based on reference battery units of a same type as the battery unit, a temperature value corresponding to the extracted parameter value and identify the temperature value as a temperature value of the battery unit at a time of obtaining the EIS data.

An operating method of a battery temperature estimation apparatus according to an embodiment disclosed herein includes obtaining electrochemical impedance spectroscopy (EIS) data of a battery unit, extracting a parameter value of a designated element of an equivalent circuit of the battery unit, based on the EIS data, identifying a temperature value corresponding to the extracted parameter value based on reference parameter values according to different temperatures, obtained based on reference battery units of a same type as the battery unit, and identifying the temperature value as the temperature value of the battery unit at a time of obtaining the EIS data.

### [ADVANTAGEOUS EFFECTS]

A battery temperature estimation apparatus and an operating method thereof according to various embodiments disclosed herein may estimate a temperature of a battery even without a temperature sensor.

The effects of the battery temperature estimation apparatus and the operating method thereof according to the disclosure of the present document are not limited to the effects mentioned above, and other effects not mentioned will be clearly understood by those of ordinary skill in the art according to the disclosure of the present document.

### [DESCRIPTION OF DRAWINGS]

FIG. 1 is a block diagram of a battery temperature estimation apparatus according to an embodiment of the present disclosure.
FIG. 2 illustrates an example of an impedance of a battery with respect to a frequency change.
FIG. 3 illustrates an example of an impedance of a battery with respect to a frequency change in different states of health (SOH).
FIG. 4 is a flowchart showing an operating method of a battery temperature estimation apparatus according to an embodiment of the present disclosure.
FIG. 5 is a flowchart showing an operating method for a battery temperature estimation apparatus according to an embodiment of the present disclosure to generate a database.

With regard to the description of the drawings, similar reference numerals may be used to refer to similar or related components.

### [MODE FOR INVENTION]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

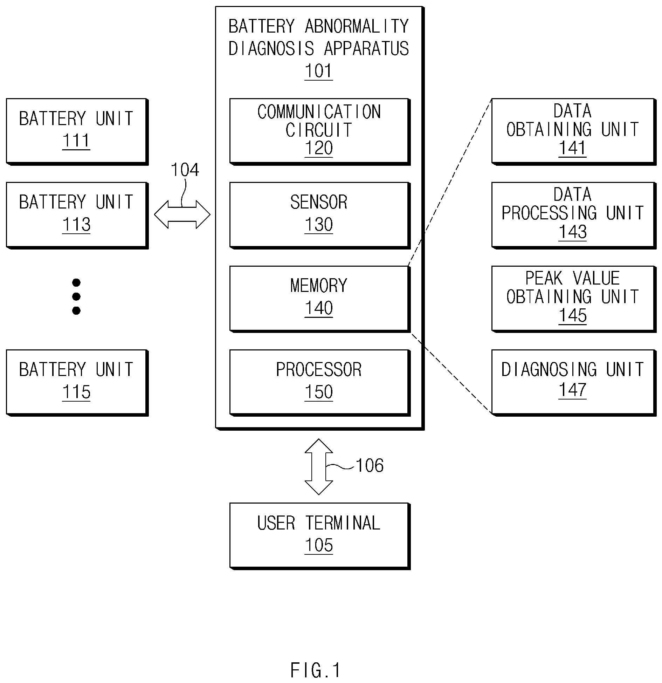

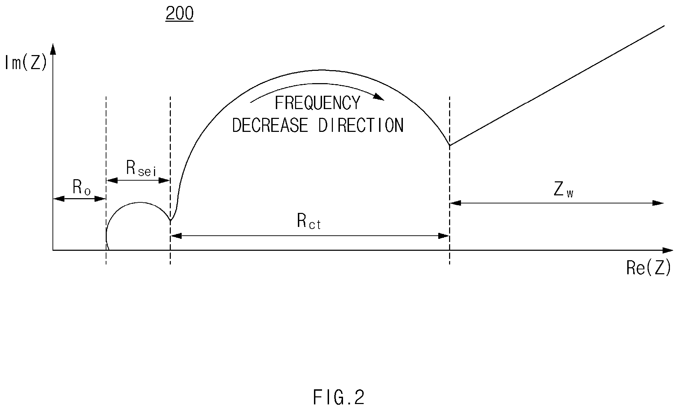

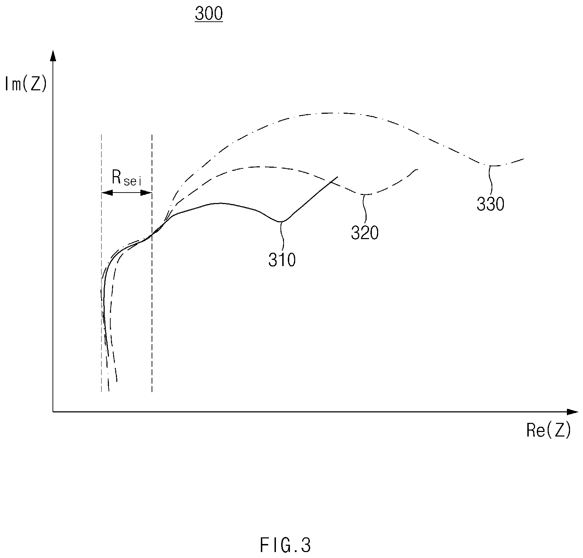

FIG. 1 is a block diagram of a battery temperature estimation apparatus 101 according to an embodiment of the present disclosure. FIG. 2 illustrates an example 200 of an impedance of a battery with respect to a frequency change. FIG. 3 illustrates an example 300 of an impedance of a battery with respect to a frequency change in different SOH.

In an embodiment, each of the one or more battery units 111, 113, and 115 may be a battery cell, a battery module, a battery pack, or a battery rack. In an embodiment, each of the battery units 111, 113, and 115 may be amounted on a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS). In this case, the battery temperature estimation apparatus 101 may be included in a mobile device (e.g., a cellular phone, a laptop computer, a smart phone, a smart pad), an electric vehicle (e.g., EV, HEV, PHEV, FCEV), an energy storage system (ESS), or a battery swapping system (BSS).

Referring to FIG. 1, the battery temperature estimation apparatus 101 may include a sensor 130, a memory 140, and a processor 150. According to an embodiment, the battery temperature estimation apparatus 101 shown in FIG. 1 may further include at least one component (e.g., a communication circuit, a display, an input device, or an output device) in addition to components shown in FIG. 1.

In an embodiment, the sensor 130 may obtain values related to states of the battery units 111, 113, and 115. In an embodiment, the values related to the states may indicate one or more values of voltages, currents, resistances of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery temperature estimation apparatus 101. For example, the data may include a database 142 (or an instruction related thereto), input data, or output data. In an embodiment, the instruction, when executed by the processor 150, may cause the battery temperature estimation apparatus 101 to perform operations defined by the instruction.

In an embodiment, the memory 140 may include one or more software (e.g., a database establishing unit 141, a data obtaining unit 143, a data extracting unit 145, and an identifying unit 147).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., the database establishing unit 141, the data processing unit 143, the data extracting unit 145, and the identifying unit 147) to control at least one other component (e.g., a hardware or software component) of the battery temperature estimation apparatus 101 connected to the processor 150 and perform various data processing or operations.

Hereinbelow, referring to FIGS. 2 and 3, a description will be made of a method, performed by the battery temperature estimation apparatus 101, of estimating temperatures of the battery units 111, 113, and 115 through the database establishing unit 141, the data obtaining unit 143, the data extracting unit 145, and the identifying unit 147.

### Establishment of Database

In an embodiment, the database establishing unit 141 may establish electrochemical impedance spectroscopy (EIS) data from reference battery units. In an embodiment, the database establishing unit 141 may obtain EIS data from the reference battery units by using the sensor 130. Herein, the reference battery units may be battery units of the same type as the battery units 111, 113, and 115.

In an embodiment, the database establishing unit 141 may obtain the EIS data while the reference battery units have a designated state of charge (SOC). Herein, the designated SOC may be 75, 90, or 100. However, the designated SOC may be set variously without being limited thereto.

In an embodiment, the database establishing unit 141 may obtain EIS data of the reference battery units at different reference temperatures. In an embodiment, the different reference temperatures may be temperatures in the unit of 5 degrees (or other units). For example, the different reference temperatures may include 10, 15, 20, 25, 30, 35, 40, and 45 degrees. However, the different reference temperatures are not limited to 10, 15, 20, 25, 30, 35, 40, and 45 degrees.

In an embodiment, the database establishing unit 141 may generate equivalent circuit models of the reference battery units based on the EIS data. Herein, the equivalent circuit models may be circuit models consisting of at least four parts. For example, the at least four parts may include a resistance (Ro) region, a solid electrolyte interphase (SEI) region, a charge transfer (CT) region, and a constant phase (i.e., Zw) region. Referring to FIG. 2, it may be seen that through the equivalent circuit model, Rsei is measured in a high-frequency region, Zw is measured in a low-frequency region, and Rct is measured between the high-frequency region and the low-frequency region.

In an embodiment, the database establishing unit 141 may generate equivalent circuit models of the reference battery units at different reference temperatures.

In an embodiment, the database establishing unit 141 may extract a resistance value of solid electrolyte interphase resistance (Rsei) in the equivalent circuit models at the different reference temperatures. For example, the database establishing unit 141 may extract the resistance value of Rsei based on a real value of an impedance in a designated frequency region (i.e., the high-frequency region). Referring to FIG. 3, the resistance value of Rsei may be similar among the battery units having the same temperature (e.g., 25 degrees), regardless of the degree of degradation. For example, it may be seen that an EIS graph 310 having an SOH of 98.6 % after 100 cycles of charging/discharging, an EIS graph 320 having an SOH of 97.3 % after 200 cycles of charging/discharging, and an EIS graph 330 having an SOH of 96.0 % after 300 cycles of charging/discharging have the same value at Rsei, but have different tendencies in other cases (e.g., at Rct).

In an embodiment, the database establishing unit 141 may generate the database 142 indicating a relationship between different reference temperatures and resistance values of Rsei. For example, the database 142 may be generated in a form in which the different reference temperatures and the resistance values of Rsei are connected in pair (e.g., temperature-Rsei pair).

In an embodiment, the database establishing unit 141 may obtain the resistance values of Rsei at the different reference temperatures and other temperatures. In an embodiment, the database establishing unit 141 may obtain the resistance values of Rsei at other temperatures based on the relationship between the different reference temperatures and the resistance values of Rsei. In an embodiment, the database establishing unit 141 may obtain the resistance values of Rsei based on interpolation.

In an embodiment, the database establishing unit 141 may obtain the resistance value of Rsei at a desired temperature through a weighted average of resistance values of Rsei at two reference temperatures closest to the desired temperature. For example, the database establishing unit 141 may obtain an average value of the resistance value of Rsei at 10 degrees and the resistance value of Rsei at 15 degrees as a resistance value of Rsei at 12.5 degrees. In another example, the database establishing unit 141 may obtain the resistance value of Rsei at 12 degrees by weighted-averaging the resistance value of Rsei at 10 degrees and the resistance value of Rsei at 15 degrees (e.g., applying a weight value of 0.6 to the resistance value of Rsei at 10 degrees and applying a weight value of 0.4 to the resistance value of Rsei at 15 degrees).

According to embodiments, the database establishing unit 141 may establish the database 142 for a different SOC. For example, the database establishing unit 141 may establish the database 142 based on a relationship between temperatures and resistance values of Rsei, obtained for an SOC of 75. The database establishing unit 141 may establish the database 142 based on a relationship between temperatures and resistance values of Rsei, obtained for an SOC of 90 and/or 100. Herein, the SOC is 75, 90, or 100 as an example, but this is merely an example. The database establishing unit 141 may establish the database 142 based on a relationship between temperatures and resistance values of Rsei, obtained for different SOCs.

### Temperature Estimation

In an embodiment, the data obtaining unit 143 may obtain EIS data of a battery unit (e.g., the battery unit 111). In an embodiment, the data obtaining unit 143 may obtain the EIS data of the battery unit through the sensor 130.

In an embodiment, the data obtaining unit 143 may obtain the EIS data of the battery unit while the battery unit has a designated SOC. In an embodiment, when the battery unit does not have the designated SOC, the battery temperature estimation apparatus 101 may charge the battery unit at the request of the data obtaining unit 143 such that the battery unit has the designated SOC. Herein, the designated SOC may be 75, 90, or 100. However, the designated SOC may be set variously without being limited thereto.

In an embodiment, the data extracting unit 145 may generate an equivalent circuit model of the battery unit based on the EIS data. Herein, the equivalent circuit models may be circuit models consisting of at least four parts. For example, at least four parts may include a Ro region, an SEI region, a CT region, and a Zw region.

In an embodiment, the data extracting unit 145 may extract a parameter value of a designated element from the equivalent circuit model of the battery unit. Herein, the designated element may be Rsei. For example, the data extracting unit 145 may extract a resistance value of Rsei from the equivalent circuit model of the battery unit.

In an embodiment, the identifying unit 147 may identify a temperature value of the battery at the time of obtaining the EIS data based on the resistance value of Rsei of the battery unit. In an embodiment, the identifying unit 147 may identify the temperature value of the battery according to the resistance value of Rsei by referring to the database 142. For example, when the resistance value of Rsei of the battery unit is 15 mΩ, the identifying unit 147 may identify the temperature value related to 15 mΩ by referring to the database 142.

In an embodiment, the identifying unit 147 may identify, as the temperature value of the battery at the time of obtaining the EIS data, the temperature value of the parameter corresponding to the extracted resistance value of Rsei among first reference parameter values (e.g., the resistance values of Rsei) according to reference temperatures and second reference parameter values (e.g., the resistance values of Rsei) interpolating the first reference parameter values.

The battery temperature estimation apparatus 101 according to an embodiment of the present disclosure described above may solve a difficulty in obtaining temperature information of the battery units 111, 113, and 115 when the battery units 111, 113, and 115 do not have a temperature sensor or communication with the battery units 111, 113, and 115 is not connected.

The battery temperature estimation apparatus 101 may generate an equivalent circuit model of the battery units 111, 113, and 115 through the EIS data of the battery units 111, 113, and 115 and use a parameter (i.e., a value of Rsei) not related to the degree of degradation of the battery units 111, 113, and 115 among parameter values (e.g., values of Rsei, Rct) that may be obtained from the equivalent circuit model, thereby precisely measuring the temperature of the battery units 111, 113, and 115.

According to embodiments, the identifying unit 147 may identify the temperature value of the battery at the time of obtaining the EIS data by referring to the database 142 established for a different SOC. For example, the identifying unit 147 may identify the temperature value of the battery according to the resistance value of Rsei by referring to the database 142 corresponding to the SOC of the battery at the time of obtaining the EIS data.

Unlike the description made with reference to FIGS. 1 to 3, the battery temperature estimation apparatus 101 according to an embodiment of the present disclosure may be used when the battery units 111, 113, and 115 include a temperature sensor.

For example, the data obtaining unit 143 may obtain EIS data of a battery unit (e.g., the battery unit 111) through the sensor 130. The data obtaining unit 143 may also obtain temperature data from the battery unit (e.g., the battery unit 111) through a communication circuit (not shown). Herein, the temperature data may be data obtained through a temperature sensor of the battery unit (e.g., the battery unit 111).

Next, the data extracting unit 145 may generate the equivalent circuit model of the battery unit based on the EIS data and then extract the resistance value of Rsei from the equivalent circuit model of the battery unit.

Next, the identifying unit 147 may identify the temperature value of the battery at the time of obtaining the EIS data based on the resistance value of Rsei of the battery unit.

Next, the identifying unit 147 may compare the identified temperature value with the temperature data obtained from the battery unit (e.g., the battery unit 111) to identify whether the temperature data is abnormal. For example, when a difference between the identified temperature value and the temperature data is greater than or equal to a threshold temperature value, the identifying unit 147 may determine that the temperature sensor of the battery unit (e.g., the battery unit 111) has an error (or a failure).

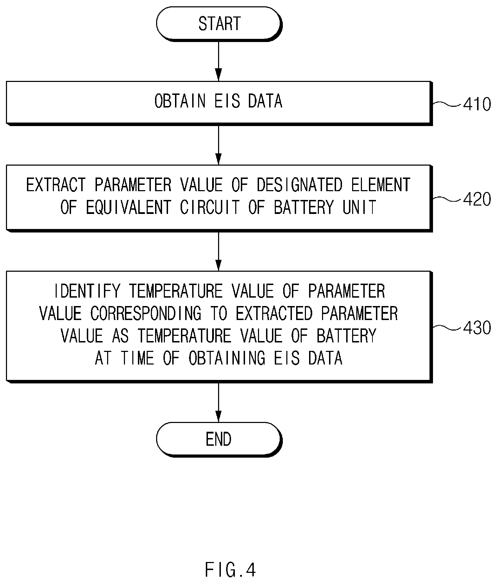

FIG. 4 is a flowchart showing an operating method of a battery temperature estimation apparatus according to an embodiment of the present disclosure. FIG. 4 will be described with reference to the components of FIG. 1.

Referring to FIG. 4, in operation 410, the battery temperature estimation apparatus 101 may obtain EIS data of a battery unit (e.g., the battery unit 111). In an embodiment, the data obtaining unit 143 may obtain the EIS data of the battery unit through the sensor 130.

In an embodiment, the battery temperature estimation apparatus 101 may obtain the EIS data of the battery unit while the battery unit has a designated SOC. In an embodiment, when the battery unit does not have the designated SOC, the battery temperature estimation apparatus 101 may charge the battery unit such that the battery unit has the designated SOC. Herein, the designated SOC may be 75, 90, or 100. However, the designated SOC may be set variously without being limited thereto.

In operation 420, the battery temperature estimation apparatus 101 may extract a parameter value of a designated element of an equivalent circuit model of the battery unit.

More specifically, the battery temperature estimation apparatus 101 may generate the equivalent circuit model of the battery unit based on the EIS data. Herein, the equivalent circuit models may be circuit models consisting of at least four parts. For example, at least four parts may include a Ro region, an SEI region, a CT region, and a Zw region.

Thereafter, the battery temperature estimation apparatus 101 may extract the parameter value of the designated element from the equivalent circuit model of the battery unit. Herein, the designated element may be Rsei. For example, the battery temperature estimation apparatus 101 may extract the resistance value of Rsei from the equivalent circuit model of the battery unit.

In operation 430, the battery temperature estimation apparatus 101 may identify the temperature value of the battery at the time of obtaining the EIS data based on the resistance value of Rsei of the battery unit. In an embodiment, the battery temperature estimation apparatus 101 may identify the temperature value of the battery according to the resistance value of Rsei by referring to the database 142.

In an embodiment, the battery temperature estimation apparatus 101 may identify, as the temperature value of the battery at the time of obtaining the EIS data, the temperature value of the parameter corresponding to the extracted resistance value of Rsei among first reference parameter values (e.g., the resistance values of Rsei) according to reference temperatures and second reference parameter values (e.g., the resistance values of Rsei) interpolating the first reference parameter values.

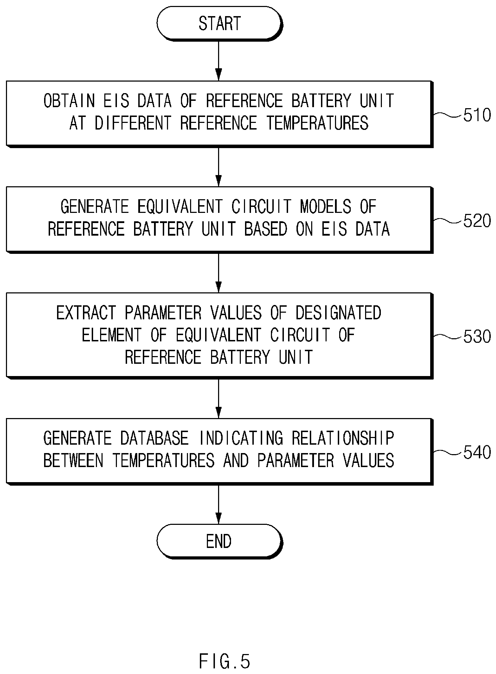

FIG. 5 is a flowchart showing an operating method for the battery temperature estimation apparatus 101 according to an embodiment of the present disclosure to generate a database. FIG. 5 will be described with reference to the components of FIG. 1.

Referring to FIG. 5, in operation 510, the battery temperature estimation apparatus 101 may obtain EIS data from reference battery units. In an embodiment, the battery temperature estimation apparatus 101 may obtain the EIS data from the reference battery units by using the sensor 130. Herein, the reference battery units may be battery units of the same type as the battery units 111, 113, and 115.

In an embodiment, the battery temperature estimation apparatus 101 may obtain the EIS data while the reference battery units have a designated SOC. Herein, the designated SOC may be 75, 90, or 100. However, the designated SOC may be set variously without being limited thereto.

In an embodiment, the battery temperature estimation apparatus 101 may obtain the EIS data of the reference battery units at different reference temperatures. In an embodiment, the different reference temperatures may be temperatures in the unit of 5 degrees. For example, the different reference temperatures may include 10, 15, 20, 25, 30, 35, 40, and 45 degrees.

In operation 520, the battery temperature estimation apparatus 101 may generate equivalent circuit models of the reference battery units based on the EIS data. Herein, the equivalent circuit models may be circuit models consisting of at least four parts. For example, the at least four parts may include a Ro region, an SEI region, a CT region, and a constant phase (i.e., Zw) region. Through the equivalent circuit model, Rsei may be measured in a high-frequency region, Zw may be measured in a low-frequency region, and Rct may be measured between the high-frequency region and the low-frequency region.

In an embodiment, the battery temperature estimation apparatus 101 may generate the equivalent circuit models of the reference battery units at different reference temperatures.

In operation 530, the battery temperature estimation apparatus 101 may extract a parameter value of a designated element of the equivalent circuit models of the reference battery units. For example, the battery temperature estimation apparatus 101 may extract the resistance value of Rsei from the equivalent circuit models at the different reference temperatures.

For example, the battery temperature estimation apparatus 101 may extract the resistance value of Rsei based on a real value of an impedance in a designated frequency region (i.e., the high-frequency region).

In operation 540, the battery temperature estimation apparatus 101 may generate the database 142 indicating a relationship between temperatures and parameter values.

In an embodiment, the battery temperature estimation apparatus 101 may generate the database 142 indicating a relationship between the different reference temperatures and the resistance values of Rsei. For example, the database 142 may be generated in a form in which the different reference temperatures and the resistance values of Rsei are connected in pair (e.g., temperature-Rsei pair).

In an embodiment, the battery temperature estimation apparatus 101 may obtain the resistance values of Rsei at the different reference temperatures and other temperatures. In an embodiment, the battery temperature estimation apparatus 101 may obtain the resistance values of Rsei at other temperatures based on the relationship between the different reference temperatures and the resistance values of Rsei. In an embodiment, the battery temperature estimation apparatus 101 may obtain the resistance values of Rsei based on interpolation.

In an embodiment, the battery temperature estimation apparatus 101 may obtain the resistance value of Rsei at a desired temperature through a weighted average of resistance values of Rsei at two reference temperatures closest to the desired temperature. For example, the database establishing unit 141 may obtain an average value of the resistance value of Rsei at 10 degrees and the resistance value of Rsei at 15 degrees as a resistance value of Rsei at 12.5 degrees. In another example, the database establishing unit 141 may obtain the resistance value of Rsei at 12 degrees by weighted-averaging the resistance value of Rsei at 10 degrees and the resistance value of Rsei at 15 degrees (e.g., applying a weight value of 0.6 to the resistance value of Rsei at 10 degrees and applying a weight value of 0.4 to the resistance value of Rsei at 15 degrees).

## Claims

1. A battery temperature estimation apparatus comprising:
a data obtaining unit configured to obtain electrochemical impedance spectroscopy (EIS) data of a battery unit;
a data extracting unit configured to extract a parameter value of a designated element of an equivalent circuit of the battery unit, based on the EIS data; and
an identifying unit configured to identify, based on reference parameter values according to different temperatures, obtained based on reference battery units of a same type as the battery unit, a temperature value corresponding to the extracted parameter value and identify the temperature value as a temperature value of the battery unit at a time of obtaining the EIS data.

2. The battery temperature estimation apparatus of claim 1, wherein the identifying unit is further configured to identify, as the temperature value of the battery unit, a temperature value of a parameter value corresponding to the extracted parameter value among the reference parameter values according to the reference temperatures.

3. The battery temperature estimation apparatus of claim 1, wherein the reference parameter values comprise first reference parameter values obtained from the reference battery units at reference temperatures and second reference parameter values obtained by interpolating the first reference parameter values, and
the second reference parameter values are parameter values for the reference temperatures and other temperatures.

4. The battery temperature estimation apparatus of claim 1, wherein the designated element is a solid electrolyte interphase resistance (Rsei).

5. The battery temperature estimation apparatus of claim 1, wherein the EIS data is data obtained at a time when a state of charge (SOC) of the battery unit has a designated SOC.

6. The battery temperature estimation apparatus of claim 1, wherein the data obtaining unit is further configured to obtain temperature data from the battery unit, and
the identifying unit is further configured to compare the temperature value with the temperature data to identify whether the temperature data is abnormal.

7. An operating method of a battery temperature estimation apparatus, the operating method comprising:
obtaining electrochemical impedance spectroscopy (EIS) data of a battery unit;
extracting a parameter value of a designated element of an equivalent circuit of the battery unit, based on the EIS data;
identifying a temperature value corresponding to the extracted parameter value based on reference parameter values according to different temperatures, obtained based on reference battery units of a same type as the battery unit; and
identifying the temperature value as the temperature value of the battery unit at a time of obtaining the EIS data.

8. The operating method of claim 7, further comprising identifying, as the temperature value of the battery unit, a temperature value of a parameter value corresponding to the extracted parameter value among the reference parameter values according to the reference temperatures.

9. The operating method of claim 7, wherein the reference parameter values comprise first reference parameter values obtained from the reference battery units at reference temperatures and second reference parameter values obtained by interpolating the first reference parameter values, and
the second reference parameter values are parameter values for the reference temperatures and other temperatures.

10. The operating method of claim 7, wherein the designated element is a solid electrolyte interphase resistance (Rsei).

11. The operating method of claim 7, wherein the EIS data is data obtained at a time when a state of charge (SOC) of the battery unit has a designated SOC.

12. The operating method of claim 7, further comprising:
obtaining temperature data from the battery unit; and
comparing the temperature value with the temperature data to identify whether the temperature data is abnormal.
